(19) Europäisches Patentamt
European Patent Office
Office européen des brevets

(11) **EP 4 194 868 B1**

(12) **EUROPEAN PATENT SPECIFICATION**

(45) Date of publication and mention
of the grant of the patent:
**15.10.2025  Bulletin 2025/42**

(21) Application number: **21917932.2**

(22) Date of filing: **23.12.2021**

(51) International Patent Classification (IPC):
*G01R 31/367* (2019.01)    *G01R 31/36* (2020.01)
*G01R 31/382* (2019.01)    *G01R 19/10* (2006.01)
*G01R 19/175* (2006.01)    *G01R 31/385* (2019.01)
*G01R 31/396* (2019.01)    *H01M 10/48* (2006.01)
*H01M 10/42* (2006.01)    *H02J 7/00* (2006.01)

(52) Cooperative Patent Classification (CPC):
**H01M 10/42; H01M 10/48; H02J 7/0047;
H02J 7/0048; H02J 7/0063; H02J 7/00714;
H02J 7/007182;** G01R 31/382; H01M 2010/4271;
Y02E 60/10

(86) International application number:
**PCT/KR2021/019714**

(87) International publication number:
**WO 2022/149770 (14.07.2022 Gazette 2022/28)**

(54) **DISCHARGE VOLTAGE GRAPH PREDICTION METHOD AND BATTERY SYSTEM USING THE SAME**

VERFAHREN ZUR VORHERSAGE EINES ENTLADUNGSSPANNUNGSGRAPHEN UND BATTERIESYSTEM DAMIT

PROCÉDÉ DE PRÉDICTION DE GRAPHE DE TENSION DE DÉCHARGE ET SYSTÈME DE BATTERIE L'UTILISANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.01.2021  KR 20210002661**

(43) Date of publication of application:
**14.06.2023  Bulletin 2023/24**

(73) Proprietor: **LG Energy Solution, Ltd.
Seoul 07335 (KR)**

(72) Inventors:
• **LEE, Sun Jong
Daejeon 34122 (KR)**
• **KIM, Cheoltaek
Daejeon 34122 (KR)**

(74) Representative: **Plasseraud IP
104 Rue de Richelieu
CS92104
75080 Paris Cedex 02 (FR)**

(56) References cited:
**EP-A1- 1 096 264        EP-A1- 1 167 987
EP-B1- 0 637 754        JP-A- 2007 163 145
JP-A- 2009 244 179        JP-A- 2013 059 244
JP-A- 2019 219 193        KR-A- 20080 000 896
US-A- 5 847 566**

## Description

### [Technical Field]

CROSS-REFERENCE TO RELATED APPLICATION

This application claims priority to and the benefit of Korean Patent Application No. 10-2021-0002661 filed in the Korean Intellectual Property Office on January 8, 2021.

The present disclosure relates to a discharge voltage graph prediction method and a battery system using the same.

### [Background Art]

In the prior art, where there is no discharge voltage graph prediction technology for lithium ion secondary batteries, direct experiments were conducted for each discharge current to obtain a discharge voltage graph, and a discharge voltage graph of a lithium ion reachable battery for the corresponding discharge current was obtained. The discharge voltage graph is a graph of the change in the battery cell voltage depending on a passage of time when being discharged with a predetermined constant current, it is necessary to measure a discharge limit current at a predetermined time, a discharge resistance at a predetermined time, or a discharge power at a predetermined time. EP0637754 B1 relates to a meter that comprises means for measuring the discharge current and terminal voltage of a battery; a data table showing the values of available capacity which are expressed by combinations of the values of different discharge currents, and the values of the terminal voltages, and prepared on the basis of the values measured in advance; storage means for storing the data table; and means for displaying on a display the value of the available capacity by reading the capacity from the storage means in accordance with the terminal current and voltage values when the battery is in use. The value of the available capacity is defined as the ratio of the total time during which the discharge with a constant current is possible at from the initial voltage in the fully charged condition to the final voltage, and the remaining time during which the discharge of constant current is possible at from the value of the measured terminal voltage to the final voltage. US5847566 A relates to a battery capacity meter and a method for precisely calculating a battery capacity are obtained by measuring a terminal voltage of the battery and sequentially calculating the measured terminal voltages. In a battery capacity meter of the present invention, a calculation process is carried out. After a power source is connected to the battery capacity meter, an initial value S0 under non-consistent charge state Si is calculated from an initial value V0 of a terminal voltage Vi. Next, Vi and Si are related to a current Ii, and an equation for relating a variation amount DELTA Si of Si to Si is formed. EP1096264 A1 relates to a device that builds up a series of threshold values of voltage related to charge status, to enable determination of current battery status. The device comprises a measuring circuit (MES) for estimating the state of charge of a rechargeable battery (BAT). This includes at least two initial threshold values corresponding to given states of charge of the battery, by comparison with the voltage on the battery terminals. This allows the state of charge of the battery to be determined from these reference calibration points. The circuit also effects a correction to these initial threshold values as a function of temperature, in order to obtain new sets of threshold value for use at different temperature. The corrected values are then used for actual determination of the state of charge of the battery. EP1167987 A1 relates to a method and apparatus by which a state of charge of a battery is accurately computed without being influenced by the polarization effect. An estimated voltage of the battery 13 in a constant load discharge with a predetermined large current value is estimated from a voltage-current characteristic when the discharge current of the constant load discharging process by the battery 13 that is in an equilibrium state is decreasing from the predetermined large current value corresponding to a maximum supplying electric power to the load. A difference between the estimated voltage and an open circuit voltage, which estimates the estimated voltage and is a terminal voltage of the battery 13 that is in an equilibrium state before the start of the constant load discharge by using the predetermined large current value, is calculated. Then, the difference is memorized by first memory means 27 for memorizing a residual voltage drop defining as the residual voltage drop due to a residual polarization at the end of the discharging process of the battery 13. The residual voltage drop memorized by the first memory means 27 is added to the estimated voltage of the battery 13, thereby a present charging capacity of the battery 13 is computed.

### [Disclosure]

[Technical Problem]

The present disclosure is to provide a discharge voltage graph prediction method that may predict the discharge voltage graph and a battery system using the same in a case of being discharged with an arbitrary constant current without information about the discharge voltage graph through experiments.

[Technical Solution]

A method for predicting a constant current discharge graph for a battery cell according to the invention is described in claim 1 and includes: selecting a discharge reference voltage as the discharge reference voltage when the discharge current is 0; measuring a first time required for the battery cell voltage to decrease to a first discharge limit voltage by a first constant current discharge; measuring a second time required for the battery cell voltage to decrease to a second discharge limit voltage by a second constant current discharge; and calculating a proportional constant and an index parameter in the relationship between the constant current and the discharge time during discharging based on the first constant current and the first time, and the second constant current and the second time. The first discharge limit voltage is a voltage obtained by subtracting the first voltage drop due to the first constant current and the internal resistance of the battery cell from the discharge reference voltage when the discharge current is 0, and the second discharge limit voltage is a voltage obtained by subtracting the second voltage drop due to the second constant current and the internal resistance of the battery cell from the discharge reference voltage.

The method of predicting the constant current discharge graph for the battery cell may further include predicting the time required for the voltage of the battery cell to reach a third discharge limit voltage by using the proportional constant and the index parameter when discharging the battery cell with the third constant current, and the third discharge limit voltage may be a voltage obtained by subtracting the third voltage drop due to the third constant current and the internal resistance of the battery cell from the discharge reference voltage.

The method of predicting the constant current discharge graph for the battery cell may further include: changing the discharge reference voltage; measuring a third time required for the battery cell voltage to decrease to a fourth discharge limit voltage by a fourth constant current discharge; measuring a fourth time required for the battery cell voltage to decrease to a fifth discharge limit voltage by a fifth constant current discharge; and calculating the proportional constant and the index parameter in the relationship between the discharge current and the time based on the fourth constant current and the third time, and the fifth constant current and the fourth time, the fourth discharge limit voltage may be a voltage obtained by subtracting the fourth voltage drop dur to the third constant current and the internal resistance of the battery cell from the changed discharge reference voltage, and the fifth discharge limit voltage may be a voltage obtained by subtracting the fifth voltage drop due to the fourth constant current and the internal resistance of the battery cell from the changed discharge reference voltage.

The method of predicting the constant current discharge graph for the battery cell may further include predicting the time required for the voltage of the battery cell to reach the sixth discharge limit voltage by using the proportional constant and the index parameter when discharging the battery cell with the sixth constant current, and the sixth discharge limit voltage is a voltage obtained by subtracting a sixth voltage drop due to the sixth constant current and the internal resistance of the battery cell from the changed discharge reference voltage.

A battery system according to the invention is described in claim 7 and includes: a plurality of battery cells; and a battery management system for predicting a discharge time required for each of a plurality of battery cell voltages to reach a corresponding discharge limit voltage during a constant current discharge. The battery management system stores information about a proportional constant and an index parameter defining a relationship between a constant current and a discharge time, a proportional constant and an index parameter about one among a plurality of battery cells is calculated based a first constant current and a first time, and a second constant current and a second time after measuring a first time required for the battery cell voltage to decrease to a first discharge limit voltage by a first constant current discharge and measuring a second time required for the battery cell voltage to decrease to a second discharge limit voltage by a second constant current discharge, and the first discharge limit voltage is a voltage obtained by subtracting the first voltage drop due to the first constant current and the internal resistance of the battery cell from a previously selected discharge reference voltage when the discharge current is 0, and the second discharge limit voltage is a voltage obtained by subtracting the second voltage drop due to the second constant current and the internal resistance of the battery cell from the discharge reference voltage.

The battery management system may predict the time required for the voltage of the battery cell to reach a third discharge limit voltage by using the proportional constant and the index parameter when discharging the battery cell with the third constant current, and the third discharge limit voltage may be a voltage obtained by subtracting the third voltage drop due to the third constant current and the internal resistance of the battery cell from the discharge reference voltage.

The SOC of the battery cell and the temperature of the cell at the time of the discharge start may be the same by the first constant current, the second constant current, and the third constant current.

The relation between the discharge current and the time may be $I = a * t^b$, where I may be the discharge current, t may be the time, a may be the proportional constant, and b may be the index parameter.

[Advantageous Effects]

If discharge occurs with a constant current that has not been tested, it is difficult to predict whether the battery cell has any kind of discharge voltage graph. An exemplary embodiment of the present invention may predict the discharge voltage graph when being discharged with an arbitrary constant current.

**[Brief Description of the Drawings]**

FIG. 1 is a graph to explain a method of predicting a discharge voltage graph according to an exemplary embodiment.

FIG. 2 is a flowchart showing a method of determining a proportional constant and an index parameter between a constant current and a discharge time according to an exemplary embodiment.

FIG. 3 is a discharge voltage graph predicted when being discharged with a predetermined current according to an exemplary embodiment.

FIG. 4 is a graph comparing a discharge voltage test result and a prediction result for each discharge current.

FIG. 5 is a graph comparing a discharge voltage test result and a prediction result for each discharge current.

FIG. 6 is a view showing a battery system to which a method of predicting a discharge voltage graph according to an exemplary embodiment is applied.

**[Modes for Invention]**

Hereinafter, embodiments disclosed in the present specification will be described in detail with reference to the accompanying drawings. In the present specification, the same or similar components will be denoted by the same or similar reference numerals, and an overlapped description thereof will be omitted. The terms "module" and "unit" for components used in the following description are used only in order to easily make a specification. Therefore, these terms do not have meanings or roles that distinguish them from each other in themselves. Further, in describing embodiments of the present specification, when it is determined that a detailed description of the well-known art associated with the present invention may obscure the gist of the present invention, it will be omitted. In addition, the accompanying drawings are provided only in order to allow embodiments disclosed in the present specification to be easily understood and are not to be interpreted as limiting the scope of the present invention, which is defined by the appended claims.

Terms including ordinal numbers such as first, second, and the like will be used only to describe various components and are not to be interpreted as limiting these components. The terms are only used to differentiate one component from other components.

It is to be understood that when one component is referred to as being "connected" or "coupled" to another component, it may be connected or coupled directly to another component or be connected or coupled to another component with the other component intervening therebetween. On the other hand, it is to be understood that when one component is referred to as being "connected or coupled directly" to another component, it may be connected to or coupled to another component without another component intervening therebetween.

It will be further understood that terms "comprise" or "have" used in the present specification specify the presence of stated features, numerals, steps, operations, components, parts, or a combination thereof, but do not preclude the presence or addition of one or more other features, numerals, steps, operations, components, parts, or a combination thereof.

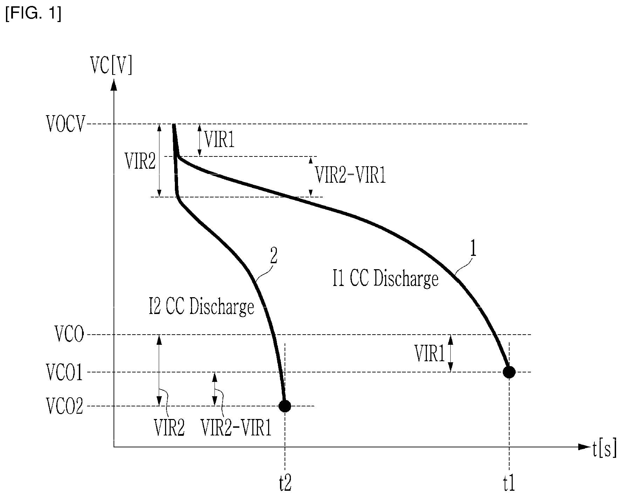

FIG. 1 is a graph to explain a method of predicting a discharge voltage graph according to an exemplary embodiment.

FIG. 1 shows a change of a battery cell voltage depending on a passage of a time when performing a discharge with different constant current (CC) from each other in a condition of a predetermined start SOC (State of Charge) and a predetermined start temperature.

First, a discharge voltage curve 1 of FIG. 1 is a graph showing the change in the battery cell voltage (VC) when being discharged with a constant current I1, and a discharge voltage curve 2 shows the change of the battery cell voltage (VC) when being discharged with a constant current I2.

In FIG. 1, "VCO" may be arbitrarily selected as the discharge reference voltage when the discharge current is 0. "VCO1" is the voltage (VCO-VIR1) obtained by subtracting the voltage drop (VIR1 = R*I1) from the discharge reference voltage (VCO) when the constant current I1 flows through the battery cell, and "VCO2" is the voltage (VCO-VIR2) obtained by subtracting the voltage drop (VIR2 = R*I2) from the discharge reference voltage (VCO) when the constant current I2 flows through the battery cell. That is, VCO1 is the discharge limit voltage when the discharge current is I1, and VOC2 is the discharge limit voltage when the discharge current is I2. In the condition that the start SOC and the start temperature are the same, respectively, when the CC discharge is performed, VCO1, VCO2, and VCO have the relationship as shown in Equation 1. The discharge limit voltage means a minimum voltage at which the battery cell voltage is capable of being reduced during the discharge, and when the battery cell is discharged to a voltage that is lower than the discharge limit voltage, the battery cell may be damaged.

[Equation 1]

$$VCO1 + R*I1 = VCO2 + R*I2 = VCO$$

As shown in FIG. 1, when the discharge starts, the battery cell voltage VC rapidly decreases from the open circuit voltage (OCV) VOCV to the voltage drop caused by the constant current and the resistance of the battery cell, and then decreases depending on the lapse of time. The battery cell voltage decreases at the discharge start by the voltage drop R*I1 due to the constant current I1 and the battery cell resistance R, and the battery cell voltage decreases depending on the lapse of time, and when the time t1 elapses, the discharge limit voltage VCO1 is reached. The battery cell voltage decreases at the discharge start by the voltage drop R*I2 due to the constant current I2 and the battery cell resistance R, and the battery cell voltage decreases depending on the lapse of time, and when the time t2 elapses, the discharge limit voltage VCO2 is reached.

The relationship between the constant current "I" and the discharge time "t" when the battery cell is discharged satisfies Equation 2 below.

[Equation 2]

$$I = a*t^b$$

In Equation 2, "a" and "b" are the proportional constant and the index parameter between the constant current and the discharge time during the discharge.

If Equation 2 is summarized with respect to time, it is as shown in Equation 3.

[Equation 3]

$$t = \left(\frac{I}{a}\right)^{\frac{1}{b}}$$

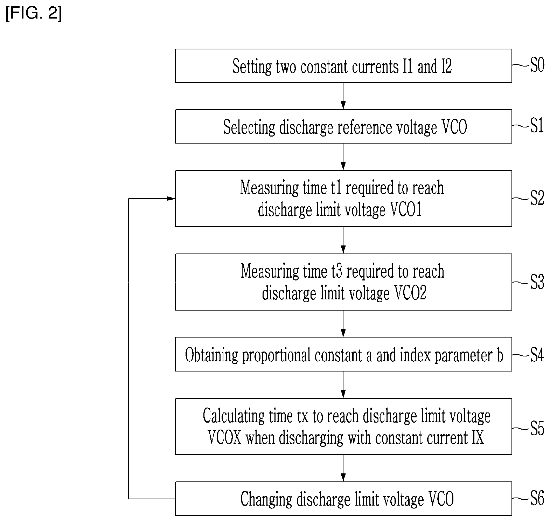

FIG. 2 is a flowchart showing a method of determining a proportional constant and an index parameter between a constant current and a discharge time according to an exemplary embodiment.

First, two constant currents I1 and I2 are set (S0).

Next, the discharge reference voltage VCO is selected (S1).

When discharging with the constant current I1, the battery cell voltage VC decreases and then the time t1 required to reach the discharge limit voltage (VCO1 = VCO -R*I1) is measured (S2).

Then, when discharging with the constant current I2, the battery cell voltage VC decreases and then the time t2 required to reach the discharge limit voltage (VCO2 = VCO -R*I2) is measured (S3).

By substituting I1 and t1, and I2 and t2 obtained through the step (S2) and the step (S3) into Equation 2, two simultaneous equations are obtained, and the proportional constant "a" and the index parameter "b" are obtained by solving two simultaneous equations (S4).

When the proportional constant "a" and the index parameter "b" are applied to Equation 3, and the discharge is performed with an arbitrary constant current Ix, the time tx to reach the discharge limit voltage (VCOx) of which the voltage drop (R*Ix) is subtracted from the discharge reference voltage (VCO) is calculated (S5).

The discharge reference voltage (VCO) is changed (S6) and the steps (S2 to S5) are repeated.

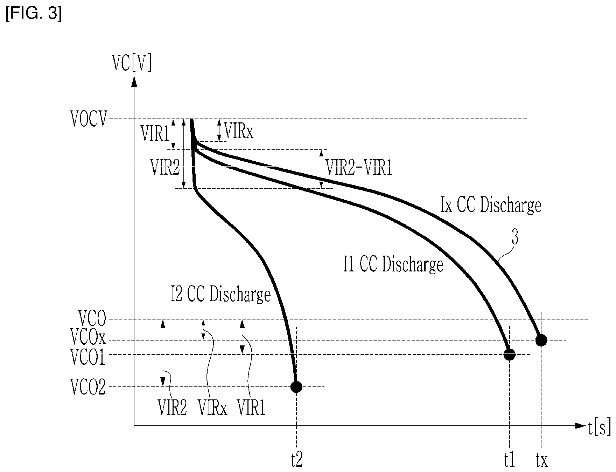

FIG. 3 is a discharge voltage graph predicted when discharge occurs with a predetermined current according to an exemplary embodiment.

To compare the times to reach the discharge limit voltage for the different constant currents I1 and I2, respectively, and the arbitrary current Ix, FIG. 3 shows together the discharge voltage graph for each of the constant currents I1 and I2.

As shown in FIG. 3, in the discharge voltage graph 3 according to an arbitrary constant current (Ix), if the discharge starts, the battery cell voltage (VC) rapidly decreases from the open circuit voltage (OCV) (VOCV) by the voltage drop (VIRx = R*Ix) due to the corresponding constant current and the resistance of the battery cell, and the battery cell voltage decreases depending on the lapse of time and reaches the discharge limit voltage (VCOx) when the time tx elapses.

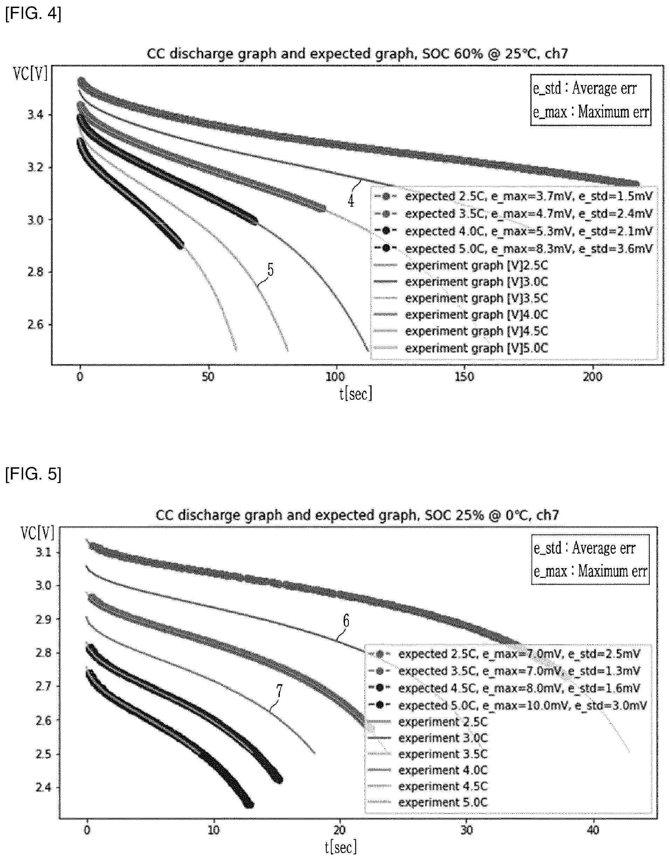

FIG. 4 is a graph comparing a discharge voltage test result and a prediction result for each discharge current.

In FIG. 4, the thin solid lines 41-46 show the discharge voltage graph according to the test result, and the thick solid lines 47-50 show the predicted discharge voltage graph.

The start SOC and start temperature are all the same SOC 60 % and 25 °C.

In FIG. 4, "C" means "C-rate", and the current corresponding to the reference capacity of the battery cell corresponds to 1 C-rate. For example, in the case of the battery cell having the reference capacity of 100 Ampere-hours (Ah), 1 C means 100 A, and 2 C means 200 A. Based on the discharge voltage graphs 42 and 45 in the discharge experiment for the constant current 3 C and 4.5 C, respectively, shown in FIG. 4, the proportional constant "a" and index parameter "b" were calculated according to the method described above.

In FIG. 4, when discharging with the constant current 2.5 C, 3.5 C, 4 C, and 5 C, respectively, the result of predicting the discharge voltage has an average error of 1 mV-3 mV obtained through the actual experiment for the discharge voltage and a maximum error range of 3 mV-8 mV. That is, as shown in FIG. 4, it may be seen that the prediction error compared to the battery cell voltage forms a significantly low value.

FIG. 5 is a graph comparing a discharge voltage test result and a prediction result for each discharge current.

In FIG. 5, the thin solid lines 51-56 show the discharge voltage graph according to the test result, and the thick solid lines 57-60 shows the predicted discharge voltage graph.

The start SOC and start temperature are all the same at SOC 25 % and 0 °C.

Based on the discharge voltage curves 53 and 55 in the discharge experiment for the constant current 2.5 C and 3.5 C, respectively, shown in FIG. 5, the proportional constant "a" and the index parameter "b" were calculated according to the method described above.

In FIG. 5, when discharging with the constant current 2.5 C, 3.5 C, 4 C, and 5 C, respectively, the results of predicting the discharge voltage have an average error of 1 mV-3 mV obtained through the actual experiment for the discharge voltage and a maximum error range of 7 mV-10 mV. That is, in the graph shown in FIG. 5, it may be seen that the prediction error compared to the battery cell voltage forms a significantly low value.

In this way, the number of experiments for acquiring the discharge voltage graph is reduced, and the duration of the experiment is reduced. In addition, since it is possible to predict the constant current discharge voltage graph, it is possible to predict the discharge limit current for any time (x seconds elapsed from the start of the discharge), the discharge resistance for any time, or the discharge power for any time as well as the measurement. The discharge limit current means the constant current when the battery cell voltage reaches the discharge limit voltage from the initial voltage for x seconds in the discharge voltage curve. The discharge resistance is calculated by dividing the value obtained by subtracting the battery cell voltage at x seconds from the initial discharge voltage of the battery cell by the discharge current. The discharge power may be calculated by dividing the area up to x seconds in the discharge voltage curve by x seconds.

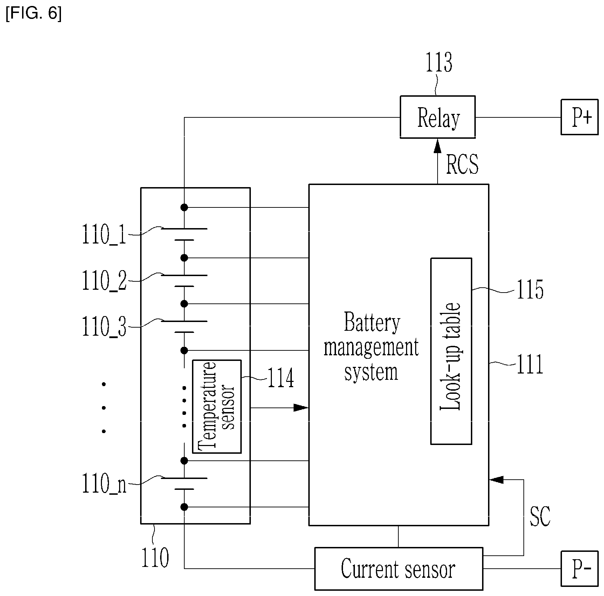

FIG. 6 is a view showing a battery system to which a method of predicting a discharge voltage graph according to an exemplary embodiment is applied.

As shown in FIG. 6, a battery system 100 includes a battery 110 including a plurality of battery cells 110_1 to 110_n connected in series, a battery management system (BMS) 111, a current sensor 112, a relay 113, and a temperature sensor 114.

The current sensor 112 may detect a current (hereinafter, a battery current) flowing through the battery 110 and transmitting a current detection signal SC indicating the detected battery current to the BMS 111. In FIG. 6, the current sensor 112 is connected between a negative electrode of the battery 110 and an output terminal (P-) of the battery 110, but unlike that shown in FIG. 6, it may be connected between the positive electrode of the battery 110 and the output terminal (P+) of the battery 110.

The temperature sensor 114 may be positioned inside the battery 110 to measure or estimate the temperature of each of a plurality of battery cells. The temperature sensor 114 may transmit a signal indicating the temperature of each of a plurality of battery cells to the BMS 111.

The BMS 111 may measure the cell voltage of a plurality of battery cells 110_1 to 110_n and measure the battery voltage that is a voltage between both terminals of the battery 110, a temperature of each of a plurality of battery cells 110_1 to 110_n, etc., and may predict the SOC of each of a plurality of battery cells 110_1 to 110_n and predict an internal resistance of each of a plurality of battery cells 110_1 to 110_n based on a plurality of battery cell voltages, the battery current, and the battery cell temperature. The method for estimating the SOC and the internal resistance is a known technique, and various methods may be applied to the present invention. The BMS 111 may control the charging and discharging based on the estimated SOC, control a balancing operation for a plurality of battery cells based on a plurality of battery cell voltages and the battery cell temperatures, and control a protection operation in a case that an overvoltage, an overcurrent, or a high temperature occur.

The relay 114 is connected between the output terminal (P+) of the battery 110 and the positive electrode of the battery 110, and opens or closes according to the relay control signal (RCS) of the BMS 111. The relay 114 may be closed according to the relay control signal (RCS) of an on-level and open according to the relay control signal (RCS) of an off-level.

According to the prediction method of the discharge voltage graph according to the discharge by the constant current described above, the BMS 111 is possible to predict the time required to reach the discharge limit voltage (VCO_i, i is a natural number from 1 to n) corresponding to each of a plurality of battery cells 110_1 to 110_n. For this, the BMS 111 may store the look-up table 115, which stores an information on the proportional constant and index parameters for each SOC and battery temperature at the start of the discharge operation.

When the discharge is performed with an arbitrary constant current (Ix) for any one of a plurality of battery cells 110_1-110_n, the BMS 111 may predict the time required to reach the discharge limit voltage (VCOx) for the corresponding battery cell voltage by using the stored proportional constant and index parameter, and Equation 3. In this case, the BMS 111 may read the proportional constant and index parameter corresponding to the same SOC and temperature as the SOC and temperature of the corresponding battery cell from the look-up table 115.

While this invention has been described in connection with what is presently considered to be practical exemplary embodiments, it is to be understood that the invention is not limited to the disclosed embodiments. On the contrary, it is intended to cover various modifications and equivalent arrangements included within the scope of the appended claims.

## Claims

1. A method for predicting a constant current discharge graph for a battery cell (110_1, ..., 110_n), comprising:

    selecting (S1) a discharge reference voltage (VCO) as the discharge reference voltage when the discharge current is 0;
    measuring (S2) a first time (t1) required for a battery cell voltage (VC) to decrease to a first discharge limit voltage (VCO1) by a first constant current discharge (I1);
    measuring (S3) a second time (t2) required for the battery cell voltage (VC) to decrease to a second discharge limit voltage (VCO2) by a second constant current discharge (I2); and calculating (S4) a proportional constant (a) and an index parameter (b) in the relationship between the constant current and the discharge time during discharging based on the first constant current (I1) and the first time (t1); and the second constant current (I2) and the second time (t2),

**characterised in that** the first discharge limit voltage (VCO1) is a voltage obtained by subtracting a first voltage drop (VIR1) due to the first constant current and the internal resistance of the battery cell from the discharge reference voltage (VCO) when the discharge current is 0, and

the second discharge limit voltage (VCO2) is a voltage obtained by subtracting a second voltage drop (VIR2) due to the second constant current and the internal resistance of the battery cell from the discharge reference voltage (VCO).

2. The method of predicting the constant current discharge graph for the battery cell of claim 1, further comprising

Predicting (S5) the time required for the voltage of the battery cell to reach a third discharge limit voltage (VCOx) by using the proportional constant (a) and the index parameter (b) when discharging the battery cell with a third constant current (Ix), and

the third discharge limit voltage (VCOx) is a voltage obtained by subtracting a third voltage drop (VIRx) due to the third constant current (Ix) and the internal resistance of the battery cell from the discharge reference voltage (VCO).

3. The method of predicting the constant current discharge graph for the battery cell of claim 2, wherein the SOC of the battery cell and the temperature of the cell at the time of the discharge start are the same by the first constant current (I1), the second constant current (I2), and the third constant current (Ix).

4. The method of predicting the constant current discharge graph for the battery cell of claim 2, further comprising:

changing the discharge reference voltage (VCO);
measuring a third time required for the battery cell voltage to decrease to a fourth discharge limit voltage by a fourth constant current discharge;
measuring a fourth time required for the battery cell voltage to decrease to a fifth discharge limit voltage by a fifth constant current discharge; and

calculating the proportional constant and the index parameter in the relationship between the discharge current and the time based on the fourth constant current and the third time, and the fifth constant current and the fourth time, wherein

the fourth discharge limit voltage is a voltage obtained by subtracting the fourth voltage drop due to the third constant current and the internal resistance of the battery cell from the changed discharge reference voltage, and the fifth discharge limit voltage is a voltage obtained by subtracting the fifth voltage drop due to the fourth constant current and the internal resistance of the battery cell from the changed discharge reference voltage.

5. The method of predicting the constant current discharge graph for the battery cell of claim 4, further comprising

predicting the time required for the voltage of the battery cell to reach the sixth discharge limit voltage by using the proportional constant and the index parameter when discharging the battery cell with the sixth constant current, and

the sixth discharge limit voltage is a voltage obtained by subtracting a sixth voltage drop due to the sixth constant current and the internal resistance of the battery cell from the changed discharge reference voltage.

6. The method of predicting the constant current discharge graph for the battery cell of claim 1, wherein

the relation between the discharge current and the time is the same as shown in Equation 1,

## [Equation 1]

$$I = a \ast t^b$$

wherein, in Equation 1, I is the discharge current, t is the time, a is the proportional constant, and b is the index parameter.

7. A battery system comprising:

a plurality of battery cells (110_1..110_n); and
a battery management system (111) configured for predicting a discharge time required for each of a plurality of battery cell voltages to reach a corresponding discharge limit voltage during a constant current discharge,
wherein the battery management system (111) is configured for storing information about a proportional constant (a) and an index parameter (b) defining a relationship between a constant current and a discharge time,

wherein the proportional constant (a) and the index parameter (b) about one among a plurality of battery cells are calculated based a first constant current (I1) and a first time (t1), and a second constant current (I2) and a second time (t2) after measuring the first time (t1) required for the battery cell voltage to decrease to a first discharge limit voltage (VCO1) by a first constant current discharge (I1) and measuring the second time (t2) required for the battery cell voltage to decrease to a second discharge limit voltage (VCO2) by a second constant current discharge (I2),

**characterised in that** the first discharge limit voltage (VCO1) is a voltage obtained by subtracting the first voltage drop (VIR1) due to the first constant current and the internal resistance of the battery cell from a previously selected discharge reference voltage (VCO) when the discharge current is 0, and the second discharge limit voltage (VCO2) is a voltage obtained by subtracting the second voltage drop (VIR2) due to the second constant current and the internal resistance of the battery cell from the discharge reference voltage (VCO).

8. The battery system of claim 7, wherein

the battery management system (111) is configured for predicting the time (tx) required for the voltage of the battery cell to reach a third discharge limit voltage (VCOx) by using the proportional constant (a) and the index parameter (b) when discharging the battery cell with the third constant current (Ix), and

the third discharge limit voltage (VCOx) is a voltage obtained by subtracting the third voltage drop (VIRx) due to the third constant current and the internal resistance of the battery cell from the discharge reference voltage (VCO).

9. The battery system of claim 8, wherein the SOC of the battery cell and the temperature of the cell at the time of the discharge start are the same by the first constant current (I1), the second constant current (I2), and the third constant current (Ix).

10. The battery system of claim 7, wherein

the relation between the discharge current and the time is the same as shown in Equation 1,

[Equation 1]

$$I = a * t^b$$

wherein, in Equation 1, I is the discharge current, t is the time, a is the proportional constant, and b is the index parameter.

**Patentansprüche**

1. Verfahren zum Vorhersagen eines Konstantstromentladung-Graphs für eine Batteriezelle (110_1, ..., 110_n), umfassend:

Auswählen (S1) einer Entladungsreferenzspannung (VCO) als die Entladungsreferenzspannung, wenn der Entladungsstrom 0 ist;
Messen (S2) einer ersten Zeit (t1), welche für eine Batteriezellenspannung (VC) benötigt wird, um sich durch eine erste Konstantstromentladung (I1) auf eine erste Entladungsbegrenzungsspannung (VCO1) zu reduzieren;
Messen (S3) einer zweiten Zeit (t2), welche für die Batteriezellenspannung (VC) benötigt wird, um sich durch eine zweite Konstantstromentladung (I2) auf eine zweite Entladungsbegrenzungsspannung (VCO2) zu reduzieren; und
Berechnen (S4) einer proportionalen Konstante (a) und eines Indexparameters (b) aus dem Verhältnis zwischen dem Konstantstrom und der Entladezeit während eines Entladens auf Grundlage des ersten Konstantstroms (I1) und der ersten Zeit (t1), und dem zweiten Konstantstrom (I2) und der zweiten Zeit (t2),
**dadurch gekennzeichnet, dass** die erste Entladungsbegrenzungsspannung (VCO1) eine Spannung ist, welche durch Subtrahieren eines ersten Spannungsabfalls (VIR1) aufgrund des ersten Konstantstroms und des internen Widerstands der Batteriezelle von der Entladungsreferenzspannung (VCO) erhalten wird, wenn der Entladungsstrom 0 ist, und
die zweite Entladungsbegrenzungsspannung (VCO2) eine Spannung ist, welche durch Subtrahieren eines zweiten Spannungsabfalls (VIR2) aufgrund des zweiten Konstantstroms und des internen Widerstands der Batteriezelle von der Entladungsreferenzspannung (VCO) erhalten wird.

2. Verfahren eines Vorhersagens des Konstantstromentladung-Graphs für die Batteriezelle nach Anspruch 1, ferner umfassend:

Vorhersagen (S5) der Zeit, welche die Spannung der Batteriezelle benötigt, um eine dritte Entladungsbegrenzungsspannung (VCOx) zu erreichen, unter Verwendung der proportionalen Konstante (a) und des Indexparameters (b), wenn die Batteriezelle mit einem dritten Konstantstrom (Ix) entladen wird, und

wobei die dritte Entladungsbegrenzungsspannung (VCOx) eine Spannung ist, welche durch Subtrahieren eines dritten Spannungsabfalls (VIRx) aufgrund des dritten Konstantstroms (Ix) und des internen Widerstands der Batteriezelle von der Entladungsreferenzspannung (VCO) erhalten wird.

3. Verfahren eines Vorhersagens des Konstantstromentladung-Graphs für die Batteriezelle nach Anspruch 2, wobei
der SOC der Batteriezelle und die Temperatur der Zelle zu der Zeit des Entladungsbeginns durch den ersten Konstantstrom (11), den zweiten Konstantstrom (12) und den dritten Konstantstrom (Ix) gleich sind.

4. Verfahren eines Vorhersagens des Konstantstromentladung-Graphs für die Batteriezelle nach Anspruch 2, ferner umfassend:

Ändern der Entladungsreferenzspannung (VCO);
Messen einer dritten Zeit, welche für die Batteriezellenspannung benötigt wird, um sich durch eine vierte Konstantstromentladung auf eine vierte Entladungsbegrenzungsspannung zu reduzieren;
Messen einer vierten Zeit, welche für die Batteriezellenspannung benötigt wird, um sich durch eine fünfte Konstantstromentladung auf eine fünfte Entladungsbegrenzungsspannung zu reduzieren; und
Berechnen der proportionalen Konstante und des Indexparameters aus dem Verhältnis zwischen dem Entladungsstrom und der Zeit auf Grundlage des vierten Konstantstroms und der dritten Zeit, und des fünften Konstantstroms und der vierten Zeit, wobei
die vierten Entladungsreferenzspannung eine Spannung ist, welche durch Subtrahieren des vierten Spannungsabfalls aufgrund des dritten Konstantstroms und des internen Widerstands der Batteriezelle von der geänderten Entladungsreferenzspannung erhalten wird, und
die fünfte Entladungsreferenzspannung eine Spannung ist, welche durch Subtrahieren des fünften Spannungsabfalls aufgrund des vierten Konstantstroms und des internen Widerstands der Batteriezelle von der geänderten Entladungsreferenzspannung erhalten wird.

5. Verfahren eines Vorhersagens des Konstantstromentladung-Graphs für die Batteriezelle nach Anspruch 4, ferner umfassend:

Vorhersagen der Zeit, welche die Spannung der Batteriezelle benötigt, um die sechste Entladungsbegrenzungsspannung zu erreichen, unter Verwendung der proportionalen Konstante und des Indexparameters, wenn die Batteriezelle mit dem sechsten Konstantstrom entladen wird, und
wobei die sechste Entladungsbegrenzungsspannung eine Spannung ist, welche durch Subtrahieren eines sechsten Spannungsabfalls aufgrund des sechsten Konstantstroms und des internen Widerstands der Batteriezelle von der geänderten Entladungsreferenzspannung erhalten wird.

6. Verfahren eines Vorhersagens des Konstantstromentladung-Graphs für die Batteriezelle nach Anspruch 1, wobei

das Verhältnis zwischen dem Entladungsstrom und der Zeit gleich wie in Gleichung 1 gezeigt ist,

[Gleichung 1]

$$I = a * t^b$$

wobei, in Gleichung 1, I der Entladungsstrom ist, t die Zeit ist, a die proportionale Konstante ist und b der Indexparameter ist.

7. Batteriesystem, umfassend:

eine Mehrzahl von Batteriezellen (110_1.. 110_n), und
ein Batterieverwaltungssystem (111), welches zum Vorhersagen einer Entladungszeit eingerichtet ist, welche für jede einer Mehrzahl von Batteriezellenspannungen benötigt wird, um eine entsprechende Entladungsbegrenzungsspannung während einer Konstantstromentladung zu erreichen,
wobei das Batterieverwaltungssystem (111) zum Speichern von Informationen über eine proportionale Konstante (a) und einen Indexparameter (b) eingerichtet ist, welche ein Verhältnis zwischen einem Konstantstrom und einer Entladungszeit definieren,
wobei die proportionale Konstante (a) und der Indexparameter (b) für eine aus der Mehrzahl von Batteriezellen auf Grundlage eines ersten Konstantstroms (11) und einer ersten Zeit (t1) sowie eines zweiten Konstantstroms (12) und einer zweiten Zeit (t2) nach einem Messen der ersten Zeit (t1), welche für die Batteriezellenspannung benötigt wird, um sich durch eine erste Konstantstromentladung (11) auf eine erste Entladungsbegrenzungsspannung (VCO1) zu reduzieren, und einem Messen der zweiten Zeit (t2) berechnet werden, welche für die Batteriezellenspannung benötigt wird, um sich durch eine zweite Konstantstromentladung (12) auf eine zweite Entladungsbegrenzungsspannung (VCO2) zu reduzieren, **dadurch gekennzeichnet, dass** die erste Entladungsbegrenzungsspannung (VCO1) eine Spannung ist, welche durch Subtrahieren des ersten Spannungsabfalls (VIR1) aufgrund des ersten Konstantstroms und des internen Widerstands der Batteriezelle von einer zuvor ausgewählten Entladungsreferenzspannung (VCO) erhalten wird, wenn der Entladungsstrom 0 ist, und

die zweite Entladungsbegrenzungsspannung (VCO2) eine Spannung ist, welche durch Subtrahieren des zweiten Spannungsabfalls (VIR2) aufgrund des zweiten Konstantstroms und des internen Widerstands der Batteriezelle von der Entladungsreferenzspannung (VCO) erhalten wird.

8. Batteriesystem nach Anspruch 7, wobei

das Batterieverwaltungssystem (111) zum Vorhersagen der Zeit (tx) eingerichtet ist, welche die Spannung der Batteriezelle benötigt, um eine dritte Entladungsbegrenzungsspannung (VCOx) zu erreichen, unter Verwendung der proportionalen Konstante (a) und des Indexparameters (b), wenn die Batteriezelle mit dem dritten Konstantstrom (Ix) entladen wird, und wobei die dritte Entladungsbegrenzungsspannung (VCOx) eine Spannung ist, welche durch Subtrahieren des dritten Spannungsabfalls (VIRx) aufgrund des dritten Konstantstroms (Ix) und des internen Widerstands der Batteriezelle von der Entladungsreferenzspannung (VCO) erhalten wird.

9. Batteriesystem nach Anspruch 8, wobei der SOC der Batteriezelle und die Temperatur der Zelle zu der Zeit des Entladungsbeginns durch den ersten Konstantstrom (I1), den zweiten Konstantstrom (I2) und den dritten Konstantstrom (Ix) gleich sind.

10. Batteriesystem nach Anspruch 7, wobei

das Verhältnis zwischen dem Entladungsstrom und der Zeit gleich wie in Gleichung 1 gezeigt ist,

[Gleichung 1]

$$I=a*t^b$$

wobei, in Gleichung 1, I der Entladungsstrom ist, t die Zeit ist, a die proportionale Konstante ist und b der Indexparameter ist.

**Revendications**

1. Procédé pour prédire un graphe de décharge à courant constant pour un élément de batterie (110_1, ..., 110_n), comprenant :

la sélection (S1) d'une tension de référence de décharge (VCO) en tant que tension de référence de décharge lorsque le courant de décharge est 0 ;
la mesure (S2) d'un premier temps (t1) requis pour qu'une tension d'élément de batterie (VC) diminue jusqu'à une première tension limite de décharge (VCO1) au moyen d'une première décharge à courant constant (I1) ;
la mesure (S3) d'un deuxième temps (t2) requis pour que la tension d'élément de batterie (VC) diminue jusqu'à une deuxième tension limite de décharge (VCO2) au moyen d'une seconde décharge à courant constant (I2) ; et
le calcul (S4) d'une constante proportionnelle (a) et d'un paramètre d'indice (b) dans la relation entre le courant constant et le temps de décharge pendant la décharge sur la base du premier courant constant (I1) et du premier temps (t1) ;
et du deuxième courant constant (I2) et du deuxième temps (t2), **caractérisé en ce que** la première tension limite de décharge (VCO1) est une tension obtenue en soustrayant une première chute de tension (VIR1) due au premier courant constant et à la résistance interne de l'élément de batterie de la tension de référence de décharge (VCO) lorsque le courant de décharge est 0, et la deuxième tension limite de décharge (VCO2) est une tension obtenue en soustrayant une deuxième chute de tension (VIR2) due au deuxième courant constant et à la résistance interne de l'élément de batterie de la tension de référence de décharge (VCO).

2. Procédé de prédiction du graphe de décharge à courant constant pour l'élément de batterie selon la revendication 1, comprenant en outre
la prédiction (S5) du temps requis pour que la tension de l'élément de batterie atteigne une troisième tension limite de décharge (VCOx) en utilisant la constante proportionnelle (a) et le paramètre d'indice (b) lors de la décharge de l'élément de batterie avec un troisième courant constant (Ix), et la troisième tension limite de décharge (VCOx) est une tension obtenue en soustrayant une troisième chute de tension (VIRx) due au troisième courant constant (Ix) et à la résistance interne de l'élément de batterie de la tension de référence de décharge (VCO).

3. Procédé de prédiction du graphe de décharge à courant constant pour l'élément de batterie selon la revendication 2, dans lequel
le SOC de l'élément de batterie et la température de l'élément au moment du début de décharge sont identiques au moyen du premier courant constant (I1), du deuxième courant constant (12) et du troisième courant constant (Ix).

4. Procédé de prédiction du graphe de décharge à courant constant pour l'élément de batterie selon la revendication 2, comprenant en outre :

la modification de la tension de référence de décharge (VCO) ;
la mesure d'un troisième temps requis pour que la tension d'élément de batterie diminue jusqu'à une quatrième tension limite de décharge au moyen d'une quatrième décharge à courant constant ;
la mesure d'un quatrième temps requis pour que la tension d'élément de batterie diminue jusqu'à une cinquième tension limite de décharge au moyen d'une cinquième décharge à courant constant ; et
le calcul de la constante proportionnelle et du paramètre d'indice dans la relation entre le courant de décharge et le temps sur la base du quatrième courant constant et du troisième temps, et du cinquième courant constant et du quatrième temps, dans lequel la quatrième tension limite de décharge est une tension obtenue en soustrayant la quatrième chute de tension due au troisième courant constant et à la résistance interne de l'élément de batterie de la tension de référence de décharge modifiée, et la cinquième tension limite de décharge est une tension obtenue en soustrayant la cinquième chute de tension due au quatrième courant constant et à la résistance interne de l'élément de batterie de la tension de référence de décharge modifiée.

5. Procédé de prédiction du graphe de décharge à courant constant pour l'élément de batterie selon la revendication 4, comprenant en outre

la prédiction du temps requis pour que la tension de l'élément de batterie atteigne la sixième tension limite de décharge en utilisant la constante proportionnelle et le paramètre d'indice lors de la décharge de l'élément de batterie avec le sixième courant constant, et
la sixième tension limite de décharge est une tension obtenue en soustrayant une sixième chute de tension due au sixième courant constant et à la résistance interne de l'élément de batterie de la tension de référence de décharge modifiée.

6. Procédé de prédiction du graphe de décharge à courant constant pour l'élément de batterie selon la revendication 1, dans lequel

la relation entre le courant de décharge et le temps est la même que celle indiquée dans l'Équation 1,

[Équation 1]

$$I = a * t^b$$

dans lequel, dans l'Équation 1, I est le courant de décharge, t est le temps, a est la constante proportionnelle, et b est le paramètre d'indice.

7. Système de batterie comprenant :

une pluralité d'éléments de batterie (110_1... 110_n) ; et
un système de gestion de batterie (111) configuré pour prédire un temps de décharge requis pour que chacune d'une pluralité de tensions d'élément de batterie atteigne une tension limite de décharge correspondante pendant une décharge à courant constant,
dans lequel le système de gestion de batterie (111) est configuré pour stocker des informations concernant une constante proportionnelle (a) et un paramètre d'indice (b) définissant une relation entre un courant constant et un temps de décharge, dans lequel la constante proportionnelle (a) et le paramètre d'indice (b) concernant un parmi une pluralité d'éléments de batterie sont calculés sur la base d'un premier courant constant (I1) et d'un premier temps (t1), et d'un deuxième courant constant (12) et d'un deuxième temps (t2) après la mesure du premier temps (t1) requis pour que la tension d'élément de batterie diminue jusqu'à une première tension limite de décharge (VCO1) au moyen d'une première décharge à courant constant (I1) et mesurer le deuxième temps (t2) requis pour que la tension d'élément de batterie diminue jusqu'à une deuxième tension limite de décharge (VCO2) au moyen d'une seconde décharge à courant constant (I2), **caractérisé en ce que** la première tension limite de décharge (VCO1) est une tension obtenue en soustrayant la première chute de tension (VIR1) due au premier courant constant et à la résistance interne de l'élément de batterie d'une tension de référence de décharge (VCO) précédemment sélectionnée lorsque le courant de décharge est 0, et la deuxième tension limite de décharge (VCO2) est une tension obtenue en soustrayant la deuxième chute de tension (VIR2) due au deuxième courant constant et à la résistance interne de l'élément de batterie de la tension de référence de décharge (VCO).

8. Système de batterie selon la revendication 7, dans lequel

le système de gestion de batterie (111) est configuré pour prédire le temps (tx) requis pour que la tension de l'élément de batterie atteigne une troisième tension limite de décharge (VCOx) en utilisant la constante proportionnelle (a) et le paramètre d'indice (b) lors de la décharge de l'élément de batterie avec le troisième courant constant (Ix), et

la troisième tension limite de décharge (VCOx) est une tension obtenue en soustrayant la troisième chute de tension (VIRx) due au troisième courant constant et à la résistance interne de l'élément de batterie de la tension de référence de décharge (VCO).

9. Système de batterie selon la revendication 8, dans lequel le SOC de l'élément de batterie et la température de l'élément au moment du début de décharge sont identiques au moyen du premier courant constant (I1), du deuxième courant constant (12) et du troisième courant constant (Ix).

10. Système de batterie selon la revendication 7, dans lequel

la relation entre le courant de décharge et le temps est la même que celle indiquée dans l'Équation 1,

[Équation 1]

$$I = a*t^b$$

dans lequel, dans l'Équation 1, I est le courant de décharge, t est le temps, a est la constante proportionnelle, et b est le paramètre d'indice.

[FIG. 1]

[FIG. 2]

| Setting two constant currents I1 and I2 | ⟞S0 |
| Selecting discharge reference voltage VCO | ⟞S1 |
| Measuring time t1 required to reach discharge limit voltage VCO1 | ⟞S2 |
| Measuring time t3 required to reach discharge limit voltage VCO2 | ⟞S3 |
| Obtaining proportional constant a and index parameter b | ⟞S4 |
| Calculating time tx to reach discharge limit voltage VCOX when discharging with constant current IX | ⟞S5 |
| Changing discharge limit voltage VCO | ⟞S6 |

[FIG. 3]

[FIG. 4]

CC discharge graph and expected graph, SOC 60% @ 25°C, ch7

[FIG. 5]

CC discharge graph and expected graph, SOC 25% @ 0°C, ch7

[FIG. 6]

**EP 4 194 868 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210002661
- EP 0637754 B1
- US 5847566 A
- EP 1096264 A1
- EP 1167987 A1